# EUROPÄISCHE PATENTSCHRIFT

(11) **EP 2 666 213 B1**
(45) Veröffentlichungstag und Bekanntmachung des Hinweises auf die Patenterteilung: **21.09.2016**
(21) Anmeldenummer: 11813785.0
(22) Anmeldetag: 28.12.2011
(51) Int. Cl.: H01S 5/20, H01S 5/32

(54) **DIODENLASER MIT HOHER EFFIZIENZ**
HIGH-EFFICIENCY DIODE LASER
LASER À DIODE À EFFICACITÉ ÉLEVÉE

(30) Priorität: 20.01.2011 DE 102011002923
(43) Veröffentlichungstag der Anmeldung: 27.11.2013
(73) Patentinhaber: Forschungsverbund Berlin E.V., 12489 Berlin (DE)
(72) Erfinder: ERBERT, Götz, 02708 Löbau (DE); WENZEL, Hans, 12355 Berlin (DE); CRUMP, Paul, 10245 Berlin (DE)
(74) Vertreter: Gulde & Partner
(86) Internationale Anmeldenummer: PCT/EP2011/074133
(87) Internationale Veröffentlichungsnummer: WO 2012/097947

(56) Entgegenhaltungen:
- WO-A1-2009/144376
- DE-A1-102009 019 996
- US-A1- 2007 002 914
- BORIS RYVKIN ET AL: "Asymmetric-Waveguide Laser Diode for High-Power Optical Pulse Generation by Gain Switching", JOURNAL OF LIGHTWAVE TECHNOLOGY, IEEE SERVICE CENTER, NEW YORK, NY, US, Bd. 27, Nr. 12, 15. Juni 2009 (2009-06-15) , Seiten 2125-2131, XP011256050, ISSN: 0733-8724
- BUDA M ET AL: "ANALYSIS OF 6-NM ALGAAS SQW LOW-CONFINEMENT LASER STRUCTURES FOR VERY HIGH-POWER OPERATION", QUANTUM ELECTRONICS, Bd. 3, Nr. 2, 1. April 1997 (1997-04-01), Seiten 173-178, XP000735906,
- WANG X ET AL: "High-power, spectrally stabilized, near-diffraction-limited 970 nm laser light source based on truncated-tapered semiconductor optical amplifiers with low confinement factors", SEMICONDUCTOR SCIENCE AND TECHNOLOGY, IOP PUBLISHING LTD, GB, Bd. 27, Nr. 1, 8. Dezember 2011 (2011-12-08), Seite 15010, XP020216318, ISSN: 0268-1242, DOI: 10.1088/0268-1242/27/1/015010
- TIJERO J M G ET AL: "Enhanced Brightness of Tapered Laser Diodes Based on an Asymmetric Epitaxial Design", IEEE PHOTONICS TECHNOLOGY LETTERS, IEEE SERVICE CENTER, PISCATAWAY, NJ, US, Bd. 19, Nr. 20, 15. Oktober 2007 (2007-10-15), Seiten 1640-1642, XP011193031, ISSN: 1041-1135, DOI: 10.1109/LPT.2007.905083
- CRUMP P ET AL: "975 nm high power diode lasers with high efficiency and narrow vertical far field enabled by low index quantum barriers", APPLIED PHYSICS LETTERS, AMERICAN INSTITUTE OF PHYSICS, 2 HUNTINGTON QUADRANGLE, MELVILLE, NY 11747, vol. 96, no. 13, 31 March 2010 (2010-03-31), pages 131110-131110, XP012130579, ISSN: 0003-6951, DOI: 10.1063/1.3378809

## Beschreibung

Die vorliegende Erfindung betrifft einen Diodenlaser mit hoher Effizienz.

### Stand der Technik

Generell besitzen kantenemittierende Laserdioden (Diodenlaser) eine aktive Schicht, welche in Halbleiterschichten eingebettet sind, die sich durch ihre Bandlücken, Brechzahlen und Dotierung voneinander unterscheiden. Die Schichten unterhalb und oberhalb der aktiven Schicht unterscheiden sich durch den Leitungstyp (n oder p). Neben der Gewährleistung des Transports von Elektronen und Löchern zur aktiven Schicht, wo sie stimuliert rekombinieren und Laserstrahlung erzeugen, dienen diese Schichten der vertikalen Führung des Laserlichtes. Die der aktiven Schicht benachbarten Schichten werden als Wellenleiterschichten bezeichnet, die diesen Schichten benachbarten als Mantelschichten. Typischerweise ist die Brechzahl der aktiven Schicht größer als die der Wellenleiterschichten und die Brechzahl der Wellenleiterschichten größer als die der Mantelschichten. Jedoch sind auch andere Konfigurationen möglich (z.B. Vertical ARROW, Photonic Band Crystal).

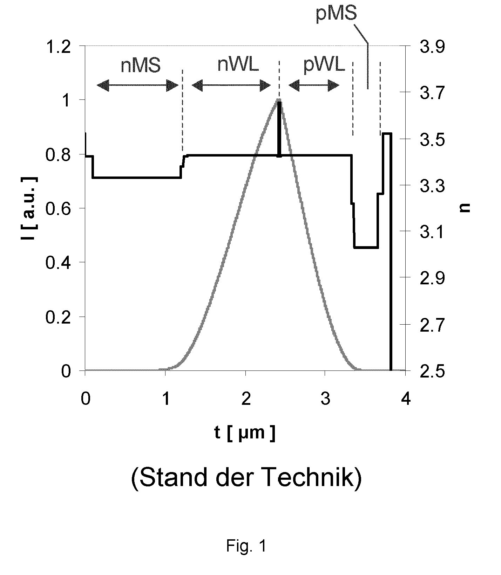

Figur 1 zeigt die Brechzahlverteilung entlang der Schichten einer herkömmlichen Laserdiode und die dazugehörige vertikale Verteilung der Modenintensität. Eine solche herkömmliche Laserdiode ist beispielsweise aus Schultz et al. "11W broad area 976 nm DFB lasers with 58% power conversion efficiency" Electron. Lett., vol 46, No. 8, pp 580-581 (2010) bekannt. Die Laserdiode weist einen vertikalen Schichtaufbau mit einer n-leitenden Mantelschicht nMS, einer darauf angeordneten, n-leitenden Wellenleiterschicht nWL, einer darauf angeordneten, vergleichsweise dünnen aktiven Schicht, einer darauf angeordneten, p-leitenden Wellenleiterschicht pWL und einer darauf angeordneten, p-leitenden Mantelschicht pMS auf. Außerhalb der genannten Schichten können weitere Schichten wie Trägersubstrat oder Kontaktschichten vorgesehen sein, die aus Gründen der Übersichtlichkeit nicht dargestellt sind. Die Wellenleiter- und Mantelschichten der genannten Struktur weisen folgenden ohmschen Widerstand auf: n-leitende Mantelschicht nMS 0,3 mΩ, n-leitende Wellenleiterschicht nWL 1,4 mΩ, p-leitende Wellenleiterschicht pWL 17, 1 mΩ und p-leitende Mantelschicht pMS 0,7 mΩ. Weiterhin weisen die Wellenleiter- und Mantelschichten der genannten Struktur folgenden optischen Verlust auf: n-leitende Mantelschicht nMS 0,02 cm⁻¹, n-leitende Wellenleiterschicht nWL 0,12 cm⁻¹, p-leitende Wellenleiterschicht pWL 0,29 cm⁻¹ und p-leitende Mantelschicht pMS 0,02 cm⁻¹. Herkömmlicherweise werden damit der optische Verlust und der ohmsche Widerstand durch die p-Wellenleiterschicht pWL dominiert.

Um den signifikanten Einfluss der p-leitenden Wellenleiterschicht auf optischen Verlust und ohmschen Widerstand zu reduzieren, ist es bekannt, einen leicht asymmetrischen Wellenleiter vorzusehen, wodurch die Energie der sich ausbildenden (Grund-)Mode zur n-leitenden Seite verlagert wird. So ist es unter anderem aus US 6,987,788 B2 und Corbett, Electron. Lett., vol 38, pp 515-516 (2002) bekannt, eine oder mehrere Zusatzschichten mit vergleichsweise hoher Brechzahl in der n-leitenden Mantelschicht oder der n-leitenden Wellenleiterschicht vorzusehen. Weiterhin ist es aus Bogatov et al. Quantum Electronics 38 (19), pp 935-939 (2008) bekannt, eine Asymmetrie zwischen p-leitender Wellenleiter- und Mantelschichten und n-leitenden Wellenleiter- und Mantelschichten vorzusehen.

Nachteilig an den vorgenannten Laserdioden ist jedoch, dass der ohmsche Widerstand nicht ausreichend reduziert und ungewollte vertikale Moden höherer Ordnung nicht ausreichend unterdrückt werden. Die Grundmode besitzt ihre maximale Intensität bei den vorgenannten Laserdioden stets in der aktiven Schicht, wodurch der minimal erreichbare optische Verlust bzw. der minimal erreichbare ohmsche Widerstand stark nach unten begrenzt sind.

Laser und/oder Verstärker sind beispielsweise aus RYVKIN B., et al.: "Asymmetric-Waveguide Laser Diode for High-Power Optical Pulse Generation by Gain Switching", JOURNAL OF LIGHTWAVE TECHNOLOGY, Bd. 27, Nr. 12, 15. Juni 2009, Seiten 2125-2131, aus BUDYA M., et al.: "ANALYSIS OF 6NM ALGAAS SQW LOW-CONFINEMENT LASER STRUCTURES FOR VERY HIGH-POWER OPERATION", QUANTUM ELECTRONICS, Bd. 3, Nr. 2, 1. April 1997, Seiten 173-174, aus WO2009/144376 A1 und aus Wang X. et al.: "High-power, spectrally stabilized, neardiffraction-limited 970 nm laser light source based on truncated-tapered semiconductor optical amplifiers with low confinement factor" SEMICONDUCTOR SCIENCE AND TECHNOLOGY, Bd. 27, Nr. 1,8. December 2011, Seite 15010, bekannt.

Letzteres offenbart eine Laserdiode gemäß dem Oberbegriff des Anspruchs 1.

### Offenbarung der Erfindung

Es ist daher Aufgabe der vorliegenden Erfindung, einen Diodenlaser mit hohem Wirkungsgrad, geringem optischen Verlust und geringem ohmschen Widerstand anzugeben. Darüber hinaus soll die erfindungsgemäße Laserdiode preiswert herstellbar sein.

Diese Aufgaben werden erfindungsgemäß durch die Merkmale des Patentanspruchs 1 gelöst. Zweckmäßige Ausgestaltungen der Erfindung sind in den Unteransprüchen enthalten.

Die Idee der vorliegenden Erfindung besteht darin, einen Diodenlaser mit einem geringen optischen Verlust und einem geringen ohmschen Widerstand zur Verfügung zu stellen, wobei die Schichtdicke der p-leitenden Wellenleiterschicht kleiner als 150 nm, vorzugsweise kleiner als 100 nm ist, während die Gesamtwellenleiterdicke (Summe der Schichtdicke der p-leitenden Wellenleiterschicht und der Schichtdicke der n-leitenden Wellenleiterschicht) größer als 1 µm ist. Dadurch kann die maximale Modenintensität der Grundmode in einen Bereich außerhalb der aktiven Schicht, vorzugsweise in ein niedrig dotiertes Gebiet der n-leitenden Wellenleiterschicht, verlagert werden. Durch ein vorteilhaftes Design von n-leitender Mantelschicht und n-leitender Wellenleiterschicht mit einem Brechzahlunterschied von kleiner als 0,04 ist es weiterhin möglich, unerwünschte Obermoden (vertikale Moden höherer Ordnung) trotz des aus der aktiven Schicht heraus verschobenen Maximums der Modenintensität der Grundmode zu unterdrücken bzw. vollständig zu eliminieren. Der erfindungsgemäße Diodenlaser weist eine erste n-leitend ausgebildete Mantelschicht, eine erste n-leitend ausgebildete Wellenleiterschicht, die (direkt) auf der ersten Mantelschicht angeordnet ist, eine aktive Schicht, die zur Strahlungserzeugung geeignet ist und die (direkt) auf der ersten Wellenleiterschicht angeordnet ist, eine zweite p-leitend ausgebildete Wellenleiterschicht, die (direkt) auf der aktiven Schicht angeordnet ist, und eine zweite p-leitend ausgebildete Mantelschicht, die (direkt) auf der zweiten Wellenleiterschicht angeordnet ist, auf, wobei die Schichtdicke der zweiten Wellenleiterschicht erfindungsgemäß kleiner als 150 nm. Die aktive Schicht weist mindestens einen Quantentopf auf und das Verhältnis der Summe der Dicken des mindestens einen Quantentopfes zum optischen Confinement Faktor (Γ) ist kleiner als 4 µm. Die Die aktive Schicht weist zudem eine (Gesamt-)Schichtdicke kleiner als 20 nm auf.

In einer bevorzugten Ausführungsvariante beträgt die Schichtdicke der zweiten Wellenleiterschicht zwischen 3 und 150 nm, wodurch eine Elektronenwelle in der aktiven Schicht effizient von der Mantelschicht ferngehalten werden kann. In einer besonders bevorzugten Ausführungsvariante beträgt die Schichtdicke der zweiten Wellenleiterschicht zwischen 5 und 100 nm, noch bevorzugter zwischen 5 und 60 nm.

Durch die geringe Schichtdicke der zweiten Wellenleiterschicht können ein geringer optischer Verlust und ein geringer ohmscher Widerstand erzielt werden. Die Differenz (Δn) der Brechzahl der ersten Wellenleiterschicht und der Brechzahl der ersten Mantelschicht liegt zwischen 0,04 und 0,01 und bevorzugter zwischen 0,04 und 0,015. Die Brechzahl bezieht sich auf die Zentralwellenlänge der von der aktiven Schicht emittierten Strahlung. Die Zentralwellenlänge der von der aktiven Schicht emittierten Strahlung liegt vorzugsweise zwischen 380 nm und 10 µm, bevorzugter zwischen 380 und 1200 nm, noch bevorzugter zwischen 700 und 1000 nm. Die erfindungsgemäße Differenz der Brechzahlen kann vorteilhafterweise bewirken, dass Obermoden unterdrückt bzw. vollständig eliminiert werden. Die spezifizierte Differenz der Brechzahlen verhindert, dass im aktiven Betrieb thermisch und elektronisch induzierte Brechzahländerungen Einfluss auf die Lasereigenschaften haben.

Vorzugsweise ist die Summe der Schichtdicke der ersten Wellenleiterschicht, der Schichtdicke der aktiven Schicht und der Schichtdicke der zweiten Wellenleiterschicht größer als 1 µm. Durch diese Ausgestaltung wird es ermöglicht, für die Grundmode ein akzeptables vertikales Fernfeld in von kleiner als 50° zu erreichen, innerhalb dessen 95% der Strahlungsleistung eingeschlossen sind bzw. abgestrahlt werden (FF95%). Weiterhin ist die Grundmode stabil gegenüber Temperatur- oder Ladungsträgereffekten (d.h. hauptsächlich von Wellenleiter- und Mantelschichten definiert). Weiterhin führt ein geringer Anteil der Grundmode innerhalb der der p-leitenden Wellenleiterschicht (vorzugsweise < 15%, beispielsweise bei 150nm p-leitenden Wellenleiterschicht und 1.15µm Gesamtdicke) zu einem möglichst geringen Verlust. Darüber hinaus besitzt die Grundmode einen geringen Anteil (bezogen auf das Leistungsmaximum) in der aktiven Schicht, d.h. die Grundmode ist nicht zentriert in der aktiven Schicht angeordnet, was zu geringen Verlusten führt.

Vorzugsweise ist die Schichtdicke der ersten Mantelschicht größer als 1 µm, bevorzugter größer als 1,2 µm, noch bevorzugter größer als 1,4 µm, noch bevorzugter größer als 1,6 µm und bevorzugter größer als 1,8 µm. Die Schichtdicke der ersten Mantelschicht ist lediglich durch praktische Wachstumsbedingungen limitiert. Es ist denkbar, das ganze Substrat als erste Mantelschicht zu nutzen.

Vorzugsweise ist das Verhältnis zwischen der Schichtdicke der ersten Mantelschicht und der Schichtdicke der ersten Wellenleiterschicht größer als 1,0, bevorzugter größer als 1,2, noch bevorzugter größer als 1,4, noch bevorzugter größer als 1,5, noch bevorzugter größer als 1,6, noch bevorzugter größer als 1,7, noch bevorzugter größer als 1,8, noch bevorzugter größer als 2,0, noch bevorzugter größer als 2,5 und noch bevorzugter größer als 3,5. Durch das Strecken der ersten Mantelschicht im Verhältnis zur ersten Wellenleiterschicht wird die Auskopplung der Grundmode in das Substrat vermieden.

Vorzugsweise sind eine Reflexionsfacette zur Reflexion der von der aktiven Schicht emittierten Strahlung und eine Austrittsfacette zur Reflexion und Auskopplung der von der aktiven Schicht emittierten Strahlung vorgesehen, wobei die Reflexionsfacette und die Austrittsfacette jeweils im Randbereich der aktiven Schicht angeordnet sind und wobei sich die Reflexionsfacette und die Austrittsfacette in Bezug auf die aktive Schicht gegenüberliegen.

Vorzugsweise weist die aktive Schicht mindestens einen Quantentopf ohne Barriereschichten auf. In einer alternativen bevorzugten Variante weist die aktive Schicht mindestens eine Topfschicht und mindestens zwei Barriereschichten auf. Vorzugsweise beträgt die Schichtdicke der mindestens einen Topfschicht zwischen 1-25 nm, bevorzugter zwischen 5-20 nm. Vorzugsweise sind die Schichtdicken der mindestens einen Topfschicht uniform und gleich. Vorzugsweise sind die Schichtdicken der optional vorhandenen Barriereschichten uniform und gleich. Die Anzahl der Topfschichten beträgt vorzugsweise kleiner 15, noch bevorzugter kleiner 10, bevorzugter kleiner 5 und noch bevorzugter kleiner 3. Vorzugsweise beträgt die Gesamtschichtdicke der aktiven Schicht (mit allen Topf- und Barriereschichten) vorzugsweise kleiner als 80 nm, bevorzugter kleiner als 60 nm, bevorzugter kleiner als 40 nm und noch bevorzugter kleiner als 20 nm.

Vorzugsweise beträgt das Verhältnis der Summe der Dicken der Quantentöpfe zum optischen Confinement-Faktor Γ (optical confinement factor) d/Γ weniger als 4 µm, bevorzugter weniger als 2 µm. Der Confimentfaktor ist das Verhältnis der optischen Intensität in den Quantentöpfen zur gesamten optischen Intensität (siehe Visser et al. ("Confinement and Modal Gain in Dielectric Waveguides", IEEE J. Lightwave Tech. Vol. 14, Nr. 5 pp. 885-887, 1996). Vorzugsweise ist der Diodenlaser für den Dauerstrichbetrieb ausgebildet Vorzugsweise ist eine elektrische Ansteuerung für den Diodenlaser derart ausgebildet, dass der Diodenlaser im Dauerstrichbetrieb arbeitet.

Vorzugsweise ist die aktive Schicht uniform ausgebildet. Vorzugsweise erstreckt sich die Uniformität der aktiven Schichte über ihre gesamte Länge, die sich zwischen den Facetten befindet, noch bevorzugter über ihre gesamte Ausdehnung. Uniformität der aktiven Schicht im Sinne der vorliegenden Anmeldung bedeutet, dass die Schichtparameter (wie chemische Zusammensetzung, Dotierung, Schichtdicke, Brechzahl) über die genannte Erstreckung relativ gesehen (Maximum zu Minimum) weniger als 10%, noch bevorzugter weniger als 5%, noch bevorzugter weniger als 1%, besonders bevorzugt gar nicht voneinander abweichen.

Vorzugsweise erstreckt sich die aktive Schicht über den gesamten Bereich zwischen der Reflexionsfacette und der Austrittsfacette. Vorzugsweise kontaktiert die aktive Schicht sowohl die Reflexionsfacette als auch die Austrittsfacette direkt. Die aktive Schicht kann auch von den Facetten in einem Bereich zwischen 0-500µm beanstandet werden, beispielsweise durch Nutzung von Implantation, Intermixing oder Überwachsen, um einen Ausfall des Lasers durch Zerstörung der Facette(n) zu verhindern.

Vorzugsweise sind die erste Mantelschicht und die erste Wellenleiterschicht auf einer ersten Seite der aktiven Schicht und die zweite Wellenleiterschicht und die zweite Mantelschicht auf einer zweiten, gegenüberliegenden Seite der aktiven Schicht angeordnet sind.

Vorzugsweise ist der Diodenlaser als kantenemittierender Diodenlaser ausgebildet. Vorzugsweise ist der Diodenlaser als optischer Verstärker ausgebildet.

Vorzugsweise sind die Oberflächen der Reflexionsfacette und der Austrittsfacette planar ausgebildet. Vorzugsweise sind die Oberflächen der Reflexionsfacette und der Austrittsfacette parallel zueinander angeordnet. Vorzugsweise verlaufen die Längsachse der ersten Wellenleiterschicht und die Längsachse der zweiten Wellenleiterschicht senkrecht zu den Oberflächen der Reflexionsfacette und der Austrittsfacette. Vorzugsweise ist ein Rippenwellenleiter zur Kontrolle des lateralen Fernfeldes vorgesehen.

Die Wellenleiterschichten im Sinne der vorliegenden Erfindung sind vorzugsweise die von beiden Seiten direkt an die aktive Schicht angrenzenden Schichten. Die Mantelschichten im Sinne der vorliegenden Erfindung sind vorzugsweise diejenigen direkt an die Wellenleiterschichten angrenzenden Schichten, die jeweils von der aktiven Schicht abgewandt sind.

Vorzugsweise sind die Wellenleiterschichten und die Mantelschichten uniform ausgebildet. Vorzugsweise erstreckt sich die Uniformität über ihre gesamte Länge, die sich zwischen den Facetten befindet, noch bevorzugter über ihre gesamte Ausdehnung. Uniformität im Sinne der vorliegenden Anmeldung bedeutet, dass die Schichtparameter (wie chemische Zusammensetzung, Dotierung, Schichtdicke, Brechzahl) über die genannte Erstreckung relativ gesehen (Maximum zu Minimum) weniger als 10%, noch bevorzugter weniger als 5%, noch bevorzugter weniger als 1%, besonders bevorzugt gar nicht voneinander abweichen.

Bevorzugtes Material der ersten Mantelschicht ist AlGaAs, bevorzugter Al_{0.20}Ga_{0.80}As. Die erste Mantelschicht weist vorzugsweise eine Schichtdicke zwischen 1000 nm und 4000 nm auf. Bevorzugtes Material der ersten Wellenleiterschicht ist AlGaAs, bevorzugter Al_{0.15}Ga_{0.85}As. Die erste Wellenleiterschicht weist vorzugsweise eine Schichtdicke zwischen 500 nm und 1800 nm auf. Als Materialien der ersten Mantelschicht und der ersten Wellenleiterschicht kommen alle Verbindungshalbleiter, bestehend aus Elementen der 3. Hauptgruppe (Al, Ga, In) und 5. Hauptgruppe (N, P, As und Sb) des Periodensystems der Elemente in Frage, welche die gewünschte Differenz (Δn) der Brechzahl der ersten Wellenleiterschicht und der Brechzahl der ersten Mantelschicht erzeugen.

Die Brechzahl der ersten Mantelschicht ist kleiner als die Brechzahl der ersten Wellenleiterschicht. Die Brechzahl der zweiten Mantelschicht ist kleiner als die Brechzahl der zweiten Wellenleiterschicht.

Bevorzugtes Material der aktiven Schicht ist ein InGaAs MQW (multi quantum well oder auch Vielfachquantentopf), bevorzugter ein InGaAs DQW (double quantum well oder auch Doppelquantentopf). Als mögliche Materialien der aktiven Schicht kommen alle Verbindungshalbleiter, bestehend aus Elementen der 3. Hauptgruppe (Al, Ga, In) und 5. Hauptgruppe (N, P, As und Sb) des Periodensystems der Elemente in Frage, z.B. als GaAsP, InGaAsP, AlInGaAs, InGaAsNSb. Bevorzugtes Material der zweiten Wellenleiterschicht ist AlGaAs, bevorzugt mit einem möglichst kleinem Al-Gehalt für einen minimalen elektrischen Widerstand, für 975nm bevorzugt < 40%, bevorzugter < 30%, bevorzugter < 15% (< Al_{0.15}Ga_{0.85}As). Die zweite Wellenleiterschicht weist vorzugsweise eine Schichtdicke kleiner als 150 nm, bevorzugter kleiner als 100 nm, noch bevorzugter kleiner als 80 nm und noch bevorzugter kleiner als 60 nm auf. Bevorzugtes Material der zweiten Mantelschicht ist AlGaAs, bevorzugter mit genügend Al, um einen Leckstrom zu vermeiden, für 975nm bevorzugt > 30%, noch bevorzugter > 40% und noch bevorzugter > 60%, z.B. Al_{0.85}Ga_{0.15}As. Als Materialien der zweiten Mantelschicht und der zweiten Wellenleiterschicht kommen alle

Verbindungshalbleiter, bestehend aus Elementen der 3. Hauptgruppe (Al, Ga, In) und 5. Hauptgruppe (N, P, As und Sb) des Periodensystems der Elemente in Frage.

Die Schichtdicke der zweiten Mantelschicht beträgt vorzugsweise zwischen 10µm und 50nm, bevorzugter zwischen 5µm und 100nm und noch bevorzugter zwischen 2µm und 200nm.

Vorzugsweise enthält mindestens eine der beiden Wellenleiterschichten einen Brechzahlgradienten (GRIN). Im Falle einer oder mehrerer Wellenleiterschichten mit einem Brechzahlgradienten, wird zur Berechnung der Differenz zwischen der Brechzahl einer Wellenleiterschicht und der Brechzahl einer dazugehörigen Mantelschicht stets der größte Betrag der Brechzahl in der jeweiligen Schicht (mit dem Brechzahlgradienten) herangezogen. Unter einer Schicht (Wellenleiterschicht) mit Brechzahlgradienten wird gemäß der vorliegenden Erfindung eine Schicht (Wellenleiterschicht) verstanden, deren Brechzahl entlang der Schichtdickenachse (quer zur Lichtausbreitungsrichtung) variiert. Vorzugsweise variiert die Brechzahl von einem ersten Wert an der ersten Grenzfläche (zur Mantelschicht) zu einem zweiten Wert an der zweiten Grenzfläche (zur aktiven Schicht). Vorzugsweise ist die Brechzahl einer Wellenleiterschicht an der Grenzfläche zur Mantelschicht geringer als an der Grenzfläche zur aktiven Schicht. Vorzugsweise variiert die Brechzahl stufenlos von der Grenzfläche zur Mantelschicht zur Grenzfläche zur aktiven Schicht. Vorzugsweise wird der Brechzahlgradient durch ein Kompositionsprofil im Halbleiter erzeugt. Zum Beispiel kann im Materialsystem AlGaAs der GRIN durch einen Gradienten des Aluminiumgehaltes erzeugt werden.

Sofern die zweite Wellenleiterschicht ein Kompositionsprofil aufweist, wird vorzugsweise AlGaAs, mit einem Aluminiumgehalt zwischen Al_{0.15}Ga_{0.85}As und Al_{0.85}Ga_{0.15}As verwendet.

Die Ausbildung eines Brechzahlgradienten in mindestens einer der Wellenleiterschichten, vorzugsweise der ersten Wellenleiterschicht ist vorteilhaft, weil dies zu einem günstigen Intensitätsprofil der Grundmode und damit zu einer niedrigen Laserschwelle führt. Einerseits wird aufgrund des erfindungsgemäßen Designs dafür gesorgt, dass die Grundmode außerhalb der aktiven Schicht liegt. Liegt die Grundmode jedoch zu weit außerhalb der aktiven Schicht, würde die Laserschwelle stark ansteigen, so dass die Ausbildung eines Brechzahlgradienten gerade zu einer optimalen Positionierung der Grundmode im Wellenleiter führt.

In einer besonders bevorzugten Ausführungsvariante weisen die erste Wellenleiterschicht und die zweite Wellenleiterschicht einen Brechzahlgradienten (durch Variation des Aluminiumgehalts entlang der Schichtdicke) auf, wobei sich der der Aluminiumgehalts bei der zweiten Wellenleiterschicht zwischen 15% und 85% und bei der ersten Wellenleiterschicht zwischen 15% und 20% variiert wird. Vorzugsweise ändert sich die Brechzahl im Falle eines Brechzahlgradienten linear von einer zur anderen Seite.

Vorzugsweise sind die erste Wellenleiterschicht und die zweite Wellenleiterschicht aus dem gleichen Material ausgebildet.

Vorzugsweise sind die aktive Schicht, die erste Mantelschicht, die zweite Mantelschicht, die erste Wellenleiterschicht und die zweite Wellenleiterschicht derart ausgebildet, dass die maximale Modenintensität der Grundmode in einem Bereich außerhalb der aktiven Schicht liegt.

Vorzugsweise ist ein Trägersubstrat vorgesehen, auf dem die genannte Schichtstruktur aufgebaut ist. Vorzugsweise sind die n-leitenden Schichten auf der Seite der aktiven Schicht angeordnet, die dem Trägersubstrat zugewandt ist, wohingegen die p-leitenden Schichten auf der Seite der aktiven Schicht angeordnet, die dem Trägersubstrat abgewandt ist. Vorzugsweise weist der Diodenlaser Kontaktschichten zur Injektion von Ladungsträgern auf.

### Kurzbeschreibung der Zeichnungen

Die Erfindung wird nachfolgend anhand von Ausführungsbeispielen näher erläutert. Es zeigen:
- Fig. 1: die Brechzahlverteilung entlang der Schichten einer herkömmlichen Laserdiode nach dem Stand der Technik sowie die dazugehörige vertikale Verteilung der Modenintensität in der Laserdiode,
- Fig. 2A: eine erfindungsgemäße Laserdiode in schematischer perspektivischer Darstellung,
- Fig. 2B: die erfindungsgemäße Laserdiode aus Fig. 2A in schematischer geschnittener Darstellung entlang einer Achse quer zur Lichtausbreitungsrichtung,
- Fig. 2C: die erfindungsgemäße Laserdiode aus Fig. 2A in schematischer geschnittener Darstellung entlang einer Achse parallel zur Lichtausbreitungsrichtung,
- Fig. 3: die Brechzahlverteilung entlang der Schichten der erfindungsgemäßen Laserdiode sowie die dazugehörige vertikale Verteilung der Modenintensität,
- Fig. 4: die Abhängigkeit des ohmschen Widerstands von der Schichtdicke der p-leitenden Wellenleiterschicht,
- Fig. 5: die Abhängigkeit des optischen Verlustes von der Schichtdicke der p-leitenden Wellenleiterschicht,
- Fig. 6: die Brechzahlverteilung entlang der Schichten der erfindungsgemäßen Laserdiode sowie die dazugehörige vertikale Verteilung der Modenintensität für die Grundmode und zwei Obermoden bei nahezu gleichen Schichtdicken von n-leitender Wellenleiterschicht und n-leitender Mantelschicht,
- Fig. 7: die Brechzahlverteilung entlang der Schichten der erfindungsgemäßen Laserdiode sowie die dazugehörige vertikale Verteilung der Modenintensität für die Grundmode und zwei Obermoden bei verbreiterter n-leitender Mantelschicht,
- Fig. 8: die Brechzahlverteilung entlang der Schichten der erfindungsgemäßen Laserdiode sowie die dazugehörige vertikale Verteilung der Modenintensität für die Grundmode und zwei Obermoden bei stark verbreiterter n-leitender Mantelschicht, und
- Fig. 9: die Abhängigkeit der in der aktiven Schicht anteiligen Strahlungsenergie Γ_{WELL} in Bezug auf eine Referenzstrahlungsenergie vom Brechzahlunterschied zwischen n-leitender Wellenleiterschicht und n-leitender Mantelschicht.

### Ausführliche Beschreibung der Zeichnungen

Fig. 1 zeigt die Brechzahlverteilung entlang der Schichten einer herkömmlichen Laserdiode nach dem Stand der Technik sowie die dazugehörige vertikale Verteilung der Modenintensität in der Laserdiode. Wie bereits in der Beschreibungseinleitung diskutiert, werden der optische Verlust und der ohmsche Widerstand durch die p-Wellenleiterschicht pWL dominiert. Aufgrund des hohen optischen Verlusts und des hohen ohmschen Widerstands ist der Wirkungsgrad des Diodenlasers stark reduziert.

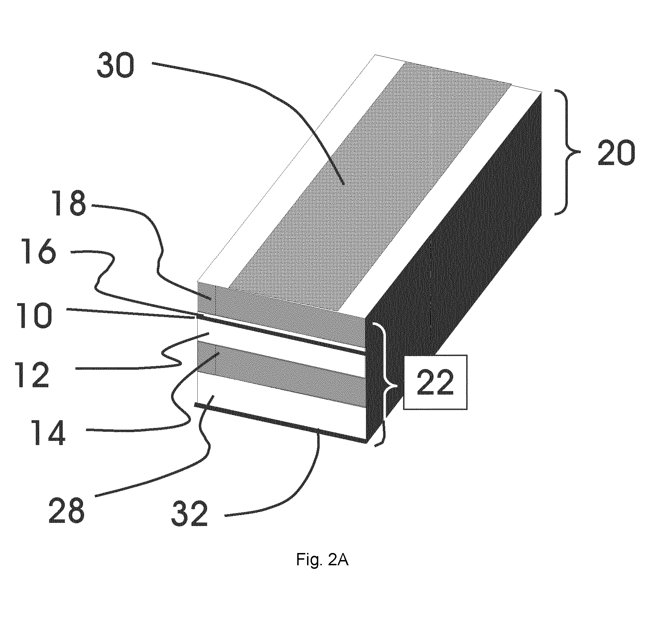

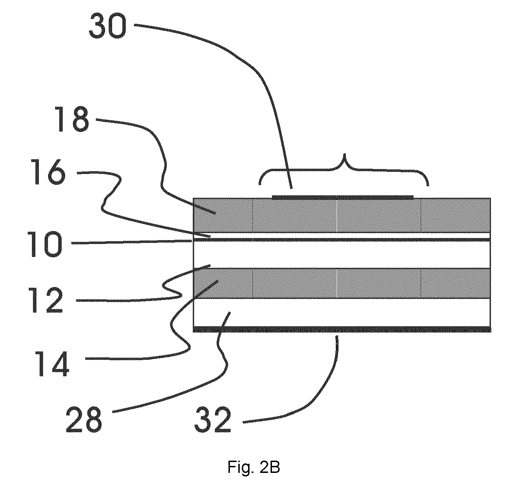

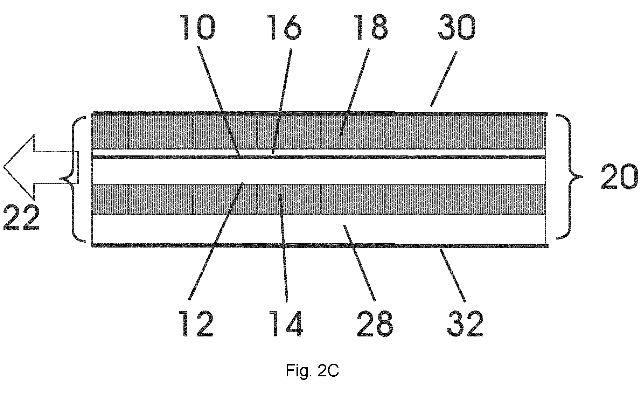

Fig. 2A-2C zeigen eine erfindungsgemäße Laserdiode in perspektivischer und geschnittener Darstellung.

Die erfindungsgemäße Laserdiode weist einen vertikalen Schichtaufbau mit einem Substrat 28, einer darauf angeordneten, ersten n-leitenden Mantelschicht 14, einer darauf angeordneten, ersten n-leitenden Wellenleiterschicht 12, einer darauf angeordneten aktiven Schicht 10, einer darauf angeordneten, zweiten p-leitenden Wellenleiterschicht 16 und einer darauf angeordneten, zweiten p-leitenden Mantelschicht 18 auf.

Weiterhin weist die erfindungsgemäße Laserdiode an den seitlichen, gegenüberliegenden Enden eine Reflexionsfacette 20 mit einer hohen Reflektivität für die Zentralwellenlänge der von der aktiven Schicht 10 emittieren Strahlung und eine Austrittsfacette 22 mit einer Reflektivität, die eine Auskopplung der Strahlung ermöglicht, auf. Die Reflektivität der Reflexionsfacette 20 beträgt vorzugsweise größer 0,8, noch bevorzugter größer 0,9 und noch bevorzugter größer 0,99. Die Reflektivität der Austrittsfacette 22 ist kleiner als die Reflektivität der Reflexionsfacette 20.

Weiterhin weist die erfindungsgemäße Laserdiode Kontakte 30 und 32 zur Injektion von Ladungsträgern auf. Durch die so gebildete Struktur können Ladungsträger einer ersten Polarität jeweils über den ersten Kontakt 30, die erste Mantelschicht 14 (hier n-leitend) und die erste Wellenleiterschicht 12 (hier n-leitend) in die aktive Schicht 10 und Ladungsträger der entgegengesetzten Polarität jeweils über den zweiten Kontakt 32, die zweite Mantelschicht 18 (hier p-leitend) und die zweite Wellenleiterschicht 16 (hier p-leitend) ebenfalls in die aktive Schicht 10 gelangen und dort rekombinieren, wodurch eine Emission hervorgerufen wird. Die Facetten 20 und 22 bilden eine Kavität, so dass ein Laserbetrieb erreicht werden kann.

Die konkrete Struktur des in den Fig. 2A-2C gezeigten, bevorzugten Ausführungsbeispiels ist ein Diodenlaser mit einer aktiven Schicht 10 mit einer zentralen Emissionswellenlänge bei 975nm, hergestellt aus einem InGaAs Doppelquantentopf. Mantel- und Wellenleiterschichten 12, 14, 16, 18 sind aus AI(x)Ga(1-x)As hergestellt. Für die Wellenleiter 12, 16 ist x in AI(x)Ga(1-x)As bevorzugt 15% (bzw. 0,15). Für die Mantelschichten 14, 18 ist x in AI(x)Ga(1-x)As bevorzugt 85% (bzw. 0,85). Im bevorzugten Ausführungsbeispiel betragen die Schichtdicke der n-leitenden Mantelschicht 14 2000nm, die Schichtdicke der n-leitenden Wellenleiterschicht 12 1100 nm, die Schichtdicke der p-leitenden Wellenleiterschicht 16 50 nm und die Schichtdicke der p-leitenden Mantelschicht 18 900 nm.

In einer alternativen bevorzugten Variante weist die p-Wellenleiterschicht 16 ein Kompositionsprofil auf, d.h. x variiert kontinuierlich (stufenlos) zwischen 15% und 85% ausgehend von der Grenzschicht zur aktiven Schicht 10 bis zur Mantelschicht 18. In diesem alternativen, bevorzugten Ausführungsbeispiel betragen die Schichtdicke der n-leitenden Mantelschicht 14 2000nm, die Schichtdicke der n-leitenden Wellenleiterschicht 12 1100 nm, die Schichtdicke der p-leitenden Wellenleiterschicht 16 100 nm und die Schichtdicke der p-leitenden Mantelschicht 18 900 nm.

In einer besonders bevorzugten Ausführungsvariante weisen die erste Wellenleiterschicht und die zweite Wellenleiterschicht einen Brechzahlgradienten (durch Variation des Aluminiumgehalts entlang der Schichtdicke) auf, wobei sich der der Aluminiumgehalts bei der zweiten Wellenleiterschicht zwischen 15% und 85% und bei der ersten Wellenleiterschicht zwischen 15% und 20% variiert wird.

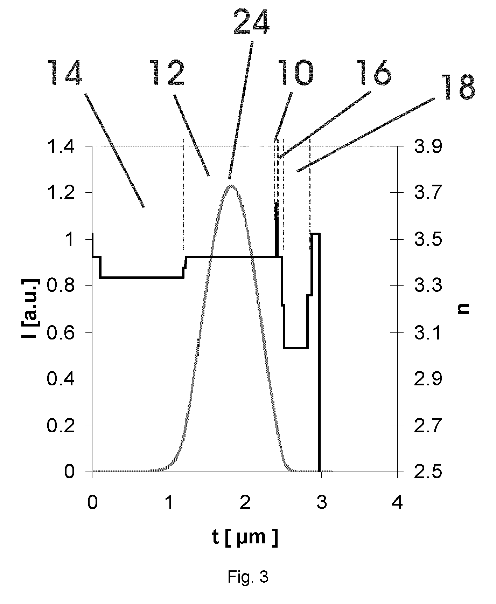

Fig. 3 zeigt die Brechzahlverteilung (Brechzahl n) der Schichten 10, 12, 14, 16 und 18 entlang einer vertikalen Achse mit symmetrischen Wellenleiterschichten sowie die dazugehörige vertikale Verteilung der Modenintensität I der Grundmode 24. Die genaue vertikale Position (Tiefe) der einzelnen Schichten 10, 12, 14, 16 und 18 entlang der vertikalen Achse ist mit t bezeichnet. Es ist deutlich zu erkennen, dass die maximale Modenintensität der Grundmode 24 mit der erfindungsgemäßen Struktur in einen Bereich außerhalb der aktiven Schicht 10 verlagert wird, wodurch der minimal erreichbare optische Verlust bzw. der minimal erreichbare ohmsche Widerstand weniger stark als im Stand der Technik nach unten begrenzt sind.

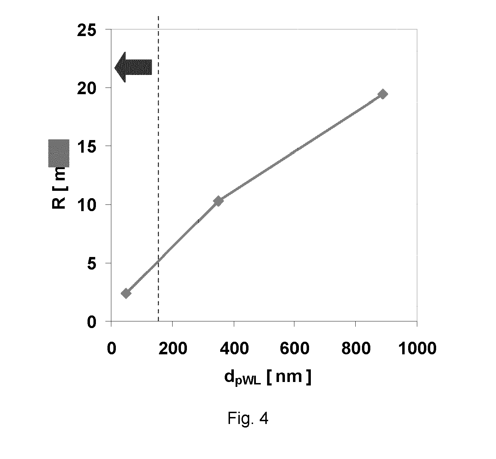

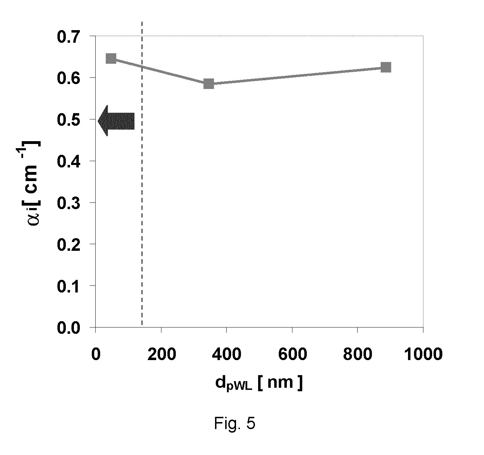

Fig. 4 und Fig. 5 zeigen einerseits die Abhängigkeit des ohmschen Widerstands von der Schichtdicke d_{pWL} der p-leitenden Wellenleiterschicht 16 und andererseits die Abhängigkeit des optischen Verlustes von der Schichtdicke d_{pWL} der p-leitenden Wellenleiterschicht 16. Es ist deutlich zu erkennen, dass der ohmsche Widerstand durch eine geringere Schichtdicke der p-leitenden Wellenleiterschicht 16 deutlich reduziert werden kann.

Die Werte für Fig. 4 und 5 wurden ohne Änderungen im Dotierungsprofil berechnet. Ein maßgeschneidertes Dotierungsprofil bringt darüber hinaus eine Reduzierung des optischen Verlustes gegenüber den Werten in der Fig. 5. Die Wellenleiter- und Mantelschichten der erfindungsgemäß endgültig optimierten Struktur weisen folgende ohmsche Widerstände auf: n-leitende Mantelschicht 14 2,3 mΩ, n-leitende Wellenleiterschicht 12 2,8 mΩ, p-leitende Wellenleiterschicht 16 2,2 mΩ und p-leitende Mantelschicht 18 1,3 mΩ. Weiterhin weisen die Wellenleiter- und Mantelschichten der genannten Struktur folgenden optischen Verlust auf: n-leitende Mantelschicht 14 zirka 0,00 cm-1, n-leitende Wellenleiterschicht 12 zirka 0,08 cm-1, p-leitende Wellenleiterschicht 16 zirka 0,00 cm-1 und p-leitende Mantelschicht 18 zirka 0,05 cm-1. Durch das erfindungsgemäße Design wird erreicht, dass der ohmsche Widerstand und optischen Verlust nicht mehr durch die p-Wellenleiterschicht 16 dominiert wird, und damit beide deutlich reduziert sind.

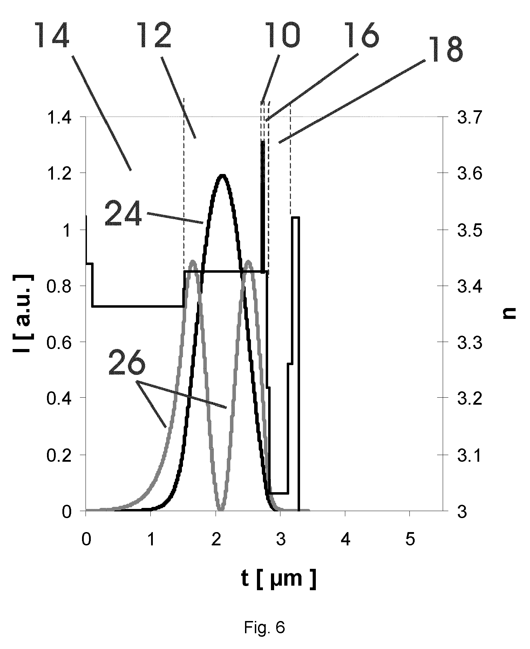

Die Figuren 6 bis 8 zeigen die Brechzahlverteilung entlang der Schichten 10, 12, 14, 16 und 18 der erfindungsgemäßen Laserdiode sowie die dazugehörige vertikale Verteilung der Modenintensität für die Grundmode 24 und zweite Obermoden 26 bei nahezu gleichen Schichtdicken von n-leitender Wellenleiterschicht 12 und n-leitender Mantelschicht 14. Im Ausführungsbeispiel der Fig. 6 betragen die Schichtdicke der n-leitender Mantelschicht 14 1000 nm und die Schichtdicke der n-leitenden Wellenleiterschicht 12 1200 nm. Es ist in Fig. 6 deutlich zu erkennen, dass die der aktiven Schicht 10 nähergelegene Obermode 26 - da die maximale Modenintensität der Grundmode 24 in einen Bereich außerhalb der aktiven Schicht 10 verlagert worden ist - einen größeren Gewinn als die Grundmode 24 aufweist, wodurch die Qualität der Laserstrahlung (insbesondere die laterale Energieverteilung) reduziert ist. Um die Anregung von Obermoden 24 zu reduzieren bzw. vollständig zu unterdrücken, ist es erfindungsgemäß vorgesehen, die Differenz der Brechzahlen zwischen der n-leitenden Mantelschicht 14 und der n-leitenden Wellenleiterschicht 12 gering zu halten.

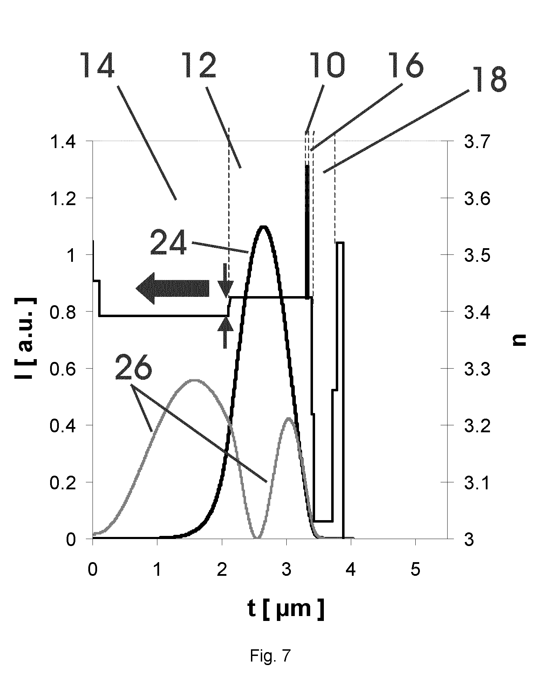

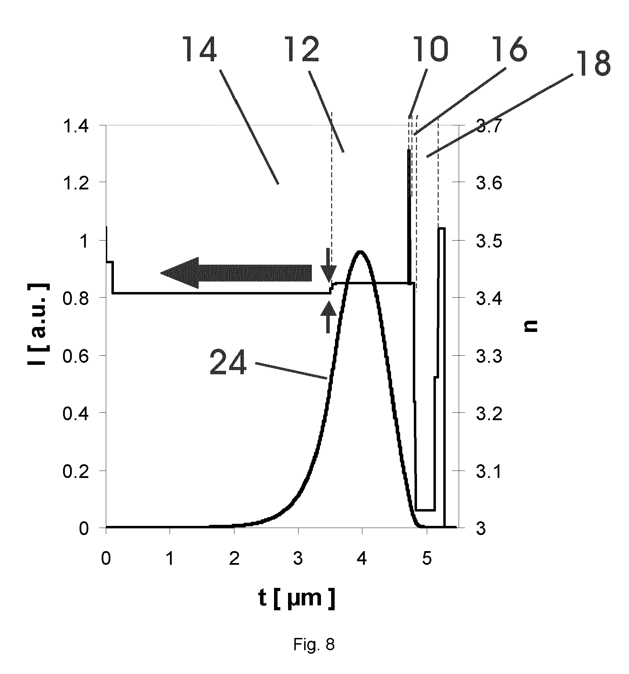

Die n-Mantelschicht ist gleichzeitig gestreckt, um eine Kopplung der Grundmode mit dem Substrat zu vermeiden. In Fig. 6 beträgt die Brechzahldifferenz (Δn) 0,009. Im Ausführungsbeispiel der Fig. 7 beträgt die Differenz (Δn) der Brechzahl der ersten Wellenleiterschicht und der Brechzahl der ersten Mantelschicht 0,0065 und die Schichtdicke der ersten (n-leitenden) Mantelschicht 2000 nm. Diese Dicke ist ausreichend, um für dieses Δn und die Schichtdicke der ersten (n-leitenden) Wellenleiterschicht von 1100 nm die Kopplung der Grundmode mit den Substratmoden zu vermeiden. Im Ausführungsbeispiel der Fig. 8 beträgt die Differenz (Δn) der Brechzahl der ersten Wellenleiterschicht und der Brechzahl der ersten Mantelschicht 0,0035. Daher muss die Schichtdicke der ersten (n-leitenden) Mantelschicht 3000 nm betragen, um für dieses Δn die Kopplung der Grundmode mit den Substratmoden zu vermeiden.

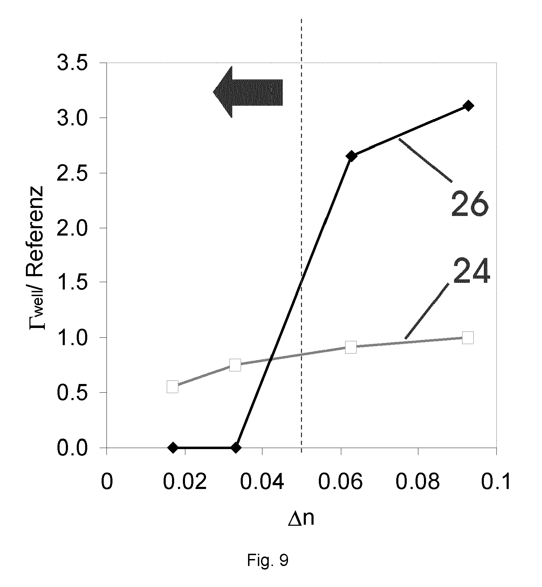

Fig. 9 zeigt die Abhängigkeit der in der aktiven Schicht 10 anteiligen Strahlungsenergie Γ_{WELL} in Bezug auf eine Referenzstrahlungsenergie vom Brechzahlunterschied Δn zwischen n-leitender Wellenleiterschicht 12 und n-leitender Mantelschicht 14. Es ist zu erkennen, dass die Intensität der Obermoden 26 mit abnehmendem Brechzahlunterschied Δn deutlich stärker abfällt als die Intensität der Grundmode 24. Daher kann durch geeigneten Wahl des Brechzahlunterschieds (Δn<0,05) eine Unterdrückung bzw. Eliminierung der Obermoden 26 erreicht werden.

### Bezugszeichenliste

- 10: Aktive Schicht
- 12: Erste Wellenleiterschicht (n-leitend)
- 14: Erste Mantelschicht (n-leitend)
- 16: Zweite Wellenleiterschicht (p-leitend)
- 18: Zweite Mantelschicht (p-leitend)
- 20: Reflexionsfacette
- 22: Austrittsfacette
- 24: Grundmode
- 26: Obermode
- 28: Substrat
- 30: Kontakt zur Injektion von Ladungsträgern
- 32: Kontakt zur Injektion von Ladungsträgern

## Patentansprüche

1. Diodenlaser, aufweisend:
eine erste n-leitend ausgebildete Mantelschicht (14),
eine erste n-leitend ausgebildete Wellenleiterschicht (12), die auf der ersten Mantelschicht (14) angeordnet ist,
eine aktive Schicht (10), die zur Strahlungserzeugung geeignet ist und die auf der ersten Wellenleiterschicht (12) angeordnet ist,
eine zweite p-leitend ausgebildete Wellenleiterschicht (16), die auf der aktiven Schicht (10) angeordnet ist, und
eine zweite p-leitend ausgebildete Mantelschicht (18), die auf der zweiten Wellenleiterschicht (16) angeordnet ist,
wobei die Summe der Schichtdicke der ersten Wellenleiterschicht (12), der Schichtdicke der aktiven Schicht (10) und der Schichtdicke der zweiten Wellenleiterschicht (16) größer als 1 µm ist und die Schichtdicke der zweiten Wellenleiterschicht (16) kleiner als 150 nm ist, wobei
die aktive Schicht (10), die erste Mantelschicht (14), die zweite Mantelschicht (18), die erste Wellenleiterschicht (12) und die zweite Wellenleiterschicht (16) derart ausgebildet sind, dass die maximale Modenintensität der Grundmode (24) in einem Bereich außerhalb der aktiven Schicht (10) liegt, **dadurch gekennzeichnet, dass** die Differenz
der Brechzahl der ersten Wellenleiterschicht (12) und der Brechzahl der ersten Mantelschicht (14) zwischen 0,04 und 0,01 beträgt, wobei die aktive Schicht (10) eine Schichtdicke kleiner als 20 nm aufweist und
die aktive Schicht (10) mindestens einen Quantentopf aufweist und das Verhältnis der Summe der Dicken des mindestens einen Quantentopfes zum optischen Confinement Faktor (Γ) kleiner als 4 µm beträgt.

2. Diodenlaser nach Anspruch 1,
**dadurch gekennzeichnet, dass**
die Schichtdicke der zweiten Wellenleiterschicht (16) kleiner als 100 nm ist.

3. Diodenlaser nach einem der vorhergehenden Ansprüche,
**dadurch gekennzeichnet, dass**
mindestens eine der Wellenleiterschichten (12, 16) einen Brechzahlgradienten aufweist, wobei die Brechzahl der Wellenleiterschicht (12, 16) entlang der Schichtdickenachse quer zur Lichtausbreitungsrichtung variiert und wobei, sofern die Brechzahl der ersten Wellenleiterschicht (12) variiert, zur Berechnung der Differenz zwischen der Brechzahl der ersten Wellenleiterschicht (12) und der Brechzahl der ersten Mantelschicht (14) der größte Betrag der Brechzahl in der ersten Wellenleiterschicht (12) herangezogen wird.

4. Diodenlaser nach einem der vorhergehenden Ansprüche,
**dadurch gekennzeichnet, dass**
die Schichtdicke der ersten Mantelschicht (14) größer als 1 µm ist.

5. Diodenlaser nach einem der vorhergehenden Ansprüche,
**dadurch gekennzeichnet, dass**
das Verhältnis zwischen der Schichtdicke der ersten Mantelschicht (14) und der Schichtdicke der ersten Wellenleiterschicht (12) größer als 1,5 ist.

6. Diodenlaser nach Anspruch 4,
**dadurch gekennzeichnet, dass**
das Verhältnis zwischen der Schichtdicke der ersten Mantelschicht (14) und der Schichtdicke der ersten Wellenleiterschicht (12) größer als 1,7 ist.

7. Diodenlaser nach einem der vorhergehenden Ansprüche,
**dadurch gekennzeichnet, dass**
eine Reflexionsfacette (20) zur Reflexion der von der aktiven Schicht (10) emittierten Strahlung und eine Austrittsfacette (22) zur Reflexion und Auskopplung der von der aktiven Schicht (10) emittierten Strahlung vorgesehen sind, wobei die Reflexionsfacette (20) und die Austrittsfacette (22) jeweils im Randbereich der aktiven Schicht (10) angeordnet sind und wobei sich die Reflexionsfacette (20) und die Austrittsfacette (22) in Bezug auf die aktive Schicht (10) gegenüberliegen.

8. Diodenlaser nach einem der vorhergehenden Ansprüche,
**dadurch gekennzeichnet, dass**
der Diodenlaser als kantenemittierender Diodenlaser oder als optischer Verstärker ausgebildet ist.

9. Diodenlaser nach einem der vorhergehenden Ansprüche,
**dadurch gekennzeichnet, dass** der Diodenlaser als cw-Diodenlaser ausgebildet ist.

## Claims

1. A diode laser, comprising:
a first n-conductively formed sheath layer (14),
a first n-conductively formed waveguide layer (12) which is arranged on the first sheath layer (14),
an active layer (10) which is adapted to generate radiation and which is arranged on the first waveguide layer (12),
a second p-conductively formed waveguide layer (16) which is arranged on the active layer (10), and
a second p-conductively formed sheath layer (18) which is arranged on the second waveguide layer (16),
wherein the sum of the layer thickness of the first waveguide layer (12), the layer thickness of the active layer (10) and the layer thickness of the second waveguide layer (16) is greater than 1 µm, and the layer thickness of the second waveguide layer (16) is less than 150 nm,
wherein the active layer (10), the first sheath layer (14), the second sheath layer (18), the first waveguide layer (12) and the second waveguide layer (16) are formed in such a way that the maximum mode intensity of the fundamental mode (24) is in a region outside the active layer (10),
**characterized in that**
the difference of the refractive index of the first waveguide layer (12) and the refractive index of the first sheath layer (14) is between 0,04 and 0,01, wherein
the active layer (10) has a layer thickness less than 20 nm, and
the active layer (10) has at least one quantum well, and the ratio of the sum of the thicknesses of the at least one quantum well to the optical confinement factor (Γ) is less than 4 µm.

2. The diode laser according to claim 1,
**characterized in that**
the layer thickness of the second waveguide layer (16) is less than 100 nm.

3. The diode laser according to one of the preceding claims,
**characterized in that**
at least one of the waveguide layers (12, 16) has a refractive index gradient, wherein the refractive index of the waveguide layer (12, 16) varies along the layer thickness axis transversely to the direction of light propagation, and wherein, provided that the refractive index of the first waveguide layer (12) varies, the largest amount of the refractive index in the first waveguide layer (12) is used to calculate the difference between the refractive index of the first waveguide layer (12) and the refractive index of the first sheath layer (14).

4. The diode laser according to one of the preceding claims,
**characterized in that**
the layer thickness of the first sheath layer (14) is greater than 1 µm.

5. The diode laser according to one of the preceding claims,
**characterized in that**
the ratio between the layer thickness of the first sheath layer (14) and the layer thickness of the first waveguide layer (12) is greater than 1,5.

6. The diode laser according to claim 4,
**characterized in that**
the ratio between the layer thickness of the first sheath layer (14) and the layer thickness of the first waveguide layer (12) is greater than 1,7.

7. The diode laser according to one of the preceding claims,
**characterized in that**
a reflection facet (20) for reflecting the radiation emitted from the active layer (10) and an exit facet (22) for reflecting and decoupling the radiation emitted from the active layer (10) are provided, wherein the reflection facet (20) and the exit facet (22) are arranged in the edge region of the active layer (10), respectively, and wherein the reflection facet (20) and the exit facet (20) are opposite each other with respect to the active layer (10).

8. The diode laser according to one of the preceding claims,
**characterized in that**
the diode laser is formed as an edge-emitting diode laser or as an optical amplifier.

9. The diode laser according to one of the preceding claims,
**characterized in that**
the diode laser is formed as a CW diode laser.

## Revendications

1. Laser à diode, comprenant:
une première couche d'enveloppe (14) à conductivité de type n,
une première couche de guide d'ondes (12) à conductivité de type n qui est disposée sur la première couche d'enveloppe (14),
une couche active (10) qui est appropriée à la génération de rayonnement et
disposée sur la première couche de guide d'ondes (12),
une deuxième couche de guide d'ondes (16) à conductivité de type p qui est disposée sur la couche active (10), et
une deuxième couche d'enveloppe (18) à conductivité de type p qui est disposée sur la deuxième couche de guide d'ondes (16),
la somme de l'épaisseur de couche de la première couche de guide d'ondes (12), de l'épaisseur de couche de la couche active (10) et de l'épaisseur de couche de la deuxième couche de guide d'ondes (16) étant supérieure à 1 µm, et l'épaisseur de couche de la deuxième couche de guide d'ondes (16) étant inférieure à 150 nm,
la couche active (10), la première couche d'enveloppe (14), la deuxième couche d'enveloppe (18), la première couche de guide d'ondes (12) et la deuxième couche de guide d'ondes (16) étant formées de telle manière que l'intensité de mode maximale du mode fondamental (24) soit située dans une zone se trouvant à l'extérieur de la couche active (10),
**caractérisé en ce que**
la différence entre l'indice de réfraction de la première couche de guide d'ondes (12) et l'indice de réfraction de la première couche d'enveloppe (14) est comprise entre 0,04 et 0,01, la couche active (10) ayant une épaisseur de couche inférieure à 20 nm, et
la couche active (10) a au moins un puits quantique, et le rapport de la somme des épaisseurs de l'au moins un puits quantique au facteur de confinement optique (Γ) est inférieur à 4 µm.

2. Laser à diode selon la revendication 1,
**caractérisé en ce que**
l'épaisseur de couche de la deuxième couche de guide d'ondes (16) est inférieure à 100 nm.

3. Laser à diode selon l'une des revendications précédentes,
**caractérisé en ce qu'**
au moins l'une des couches de guide d'ondes (12, 16) a un gradient d'indice de réfraction, l'indice de réfraction de la couche de guide d'ondes (12, 16) variant le long de l'axe d'épaisseur de couche transversalement à la direction de propagation de la lumière, et, pourvu que l'indice de réfraction de la première couche de guide d'ondes (12) varie, le plus grand montant de l'indice de réfraction dans la première couche de guide d'ondes (12) étant utilisé pour calculer la différence entre l'indice de réfraction de la première couche de guide d'ondes (12) et l'indice de réfraction de la première couche d'enveloppe (14).

4. Laser à diode selon l'une des revendications précédentes,
**caractérisé en ce que**
l'épaisseur de couche de la première couche d'enveloppe (14) est supérieure à 1 µm

5. Laser à diode selon l'une des revendications précédentes,
**caractérisé en ce que**
le rapport entre l'épaisseur de couche de la première couche d'enveloppe (14) et l'épaisseur de couche de la première couche de guide d'ondes (12) est supérieur à 1,5.

6. Laser à diode selon la revendication 4,
**caractérisé en ce que**
le rapport entre l'épaisseur de couche de la première couche d'enveloppe (14) et l'épaisseur de couche de la première couche de guide d'ondes (12) est supérieur à 1,7.

7. Laser à diode selon l'une des revendications précédentes,
**caractérisé en ce qu'**
une facette de réflexion (20) conçue pour réfléchir le rayonnement émis par la couche active (10) et une facette de sortie (22) conçue pour réfléchir et découpler le rayonnement émis par la couche active (10) sont prévues, la facette de réflexion (20) et la facette de sortie (22) étant disposées dans la zone de bord de la couche active (10), respectivement, et la facette de réflexion (20) et la facette de sortie (22) étant opposées l'une à l'autre par rapport à la couche active (10).

8. Laser à diode selon l'une des revendications précédentes,
**caractérisé en ce que**
le laser à diode est formé en tant que laser à diode à émission de bord ou en tant qu'amplificateur optique.

9. Laser à diode selon l'une des revendications précédentes,
**caractérisé en ce que**
le laser à diode est formé en tant que laser à diode à onde entretenue.
